Europäisches Patentamt

European Patent Office

Office européen des brevets

(19)

(11) Numéro de publication : **0 448 475 A1**

# (12) DEMANDE DE BREVET EUROPEEN

(21) Numéro de dépôt : 91400775.2

(22) Date de dépôt : 21.03.91

(51) Int. Cl.⁵ : **G01R 33/24, G01R 33/42**

(30) Priorité : 23.03.90 FR 9003739

(43) Date de publication de la demande :
25.09.91 Bulletin 91/39

(84) Etats contractants désignés :
**DE GB IT SE**

(71) Demandeur : **COMMISSARIAT A L'ENERGIE
ATOMIQUE
31-33, rue de la Fédération
F-75015 Paris (FR)**

(72) Inventeur : **Alcouffe, François
7 Avenue F. Viallet
F-38000 Grenoble (FR)**
Inventeur : **Crescini, Jean
26 rue de Montroux
F-38420 Domene (FR)**
Inventeur : **Duret, Denis
13 rue de Stalingrad
F-38100 Grenoble (FR)**

(74) Mandataire : **Signore, Robert et al
c/o BREVATOME 25, rue de Ponthieu
F-75008 Paris (FR)**

(54) **Magnétomètre à blindage perfectionné.**

(57) Le magnétomètre (80) est entouré d'un blindage sphérique (60, 70). De manière avantageuse, ce blindage est formé de deux hémisphères (60, 70).
Application à la mesure du champ magnétique terrestre.

EP 0 448 475 A1

Jouve, 18, rue Saint-Denis, 75001 PARIS

FIG. 3

## MAGNÉTOMETRE A BLINDAGE PERFECTIONNE

La présente invention a pour objet un magnétomètre à blindage perfectionné. Elle trouve une application dans la mesure précise des champs magnétiques lentement variables, notamment du champ magnétique terrestre dont la valeur est d'environ $2,3.10^{-5}$ à $7.10^{-5}$ Tesla, selon la latitude.

Le magnétomètre de l'invention est soit du type oscillateur à résonance magnétique nucléaire (R.M.N.), soit du type oscillateur à résonance paramagnétique électronique (R.P.E.). De tels magnétomètres sont connus et sont décrits par exemple dans les demandes de brevets français FR-A-2 583 887 et FR-A-2 603 384 respectivement. Il n'est donc pas utile de le décrire en détail.

Il convient cependant de rappeler que le fonctionnement d'un magnétomètre repose sur le principe de la résonance magnétique des protons ou des électrons, qui, en présence d'un champ magnétique B, précessionnent autour de la direction dudit champ à une fréquence F, appelée "fréquence de LARMOR", proportionnelle au module de B :

$$F = \frac{\gamma}{2\pi} . B$$

où $\gamma$ désigne le rapport gyromagnétique du proton ou de l'électron.

Compte tenu des valeurs prises par le champ terrestre, les fréquences de résonance observées sont situées entre 1000 et 3000 Hertz pour les magnétomètres à R.M.N. et entre $0,7.10^6$ et $2.10^6$ Hertz pour les magnétomètres à R.P.E.

Ces magnétomètres peuvent voir leurs performances détériorées par la présence de signaux parasites tombant dans la plage de mesure. Il peut s'agir des harmoniques des fréquences industrielles (50 ou 400 Hertz) pour les magnétomètres à R.M.N. ou des ondes radio pour les magnétomètres à R.P.E.

Par ailleurs, la présence d'un gradient de champ notable (supérieur à 100 nanoTesla par mètre) détériore les performances d'un magnétomètre à R.M.N. Le magnétomètre à R.P.E., quant à lui, est beaucoup moins sensible au gradient : le gradient doit excéder 50 microTesla par mètre pour observer une détérioration du signal.

Il convient donc, si l'on cherche à optimiser le fonctionnement des magnétomètres, de les protéger au mieux contre les signaux parasites, tout en permettant la mesure des champs continus ou lentement variables (de 0 à 1 Hz) comme le champ magnétique terrestre.

Le problème technique posé (protection contre les champs électromagnétiques alternatifs, tout en permettant la transmission des champs continus ou lentement variables) trouve une solution connue dans le blindage de la sonde par un écran passif électromagnétique.

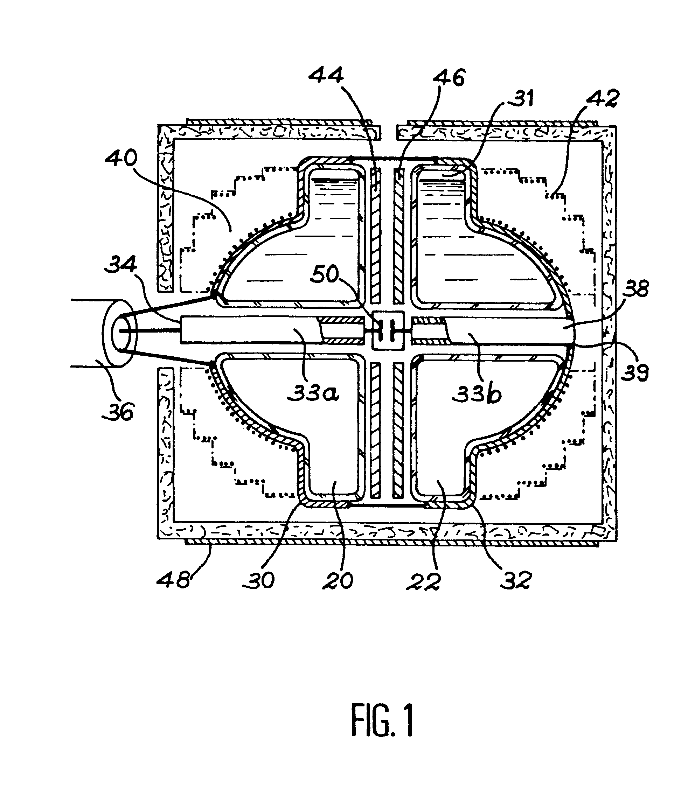

La figure 1 annexée montre, à titre d'exemple, une sonde de magnétomètre à RMN blindée selon une disposition décrite dans FR-A-2 583 887 déjà cité.

Telle que représentée, la sonde comprend deux flacons 20, 22 à solution radicalaire. Ces deux flacons sont revêtus extérieurement d'une couche métallique argentée, respectivement 30 et 32, divisée en secteurs non jointifs (pour éviter les courants de FOUCAULT circonférentiels). La sonde comprend encore un conducteur central formé de deux demi-tronçons 33a et 33b. L'extrémité gauche 34 du tronçon 33a est reliée à l'âme centrale d'un câble coaxial d'alimentation 36 tandis que l'extrémité droite 38 du tronçon 33b est connectée à la couche conductrice 32 du flacon 22 par des bandes conductrices 39. Un condensateur d'accord 50 est prévu entre les tronçons 33a et 33b. Les enroulements de prélèvement et d'excitation de cette sonde comprennent deux enroulements hémisphériques 40 et 42 extérieurs au résonateur et, deux bobines plates 44 et 46 intérieures au résonateur.

Le blindage de cette sonde est de forme cylindrique et se compose de bandes métalliques 48 (par exemple en argent) déposées sur un support isolant.

Bien que donnant satisfaction à certains égards, un tel dispositif présente un inconvénient pour ce qui est du blindage. Il faut rappeler en effet que la mesure des variations du champ terrestre vise à détecter des anomalies magnétiques, signes de la présence, par exemple, d'une structure ferromagnétique immergée (navire ou autre). Les mesures s'effectuent à distance, la sonde étant embarquée sur un avion ou un hélicoptère. Or, de tels porteurs sont inévitablement soumis à des mouvements de rotation (roulis, tangage, lacet). Ces mouvements, appliqués au magnétomètre et à son blindage, provoquent l'apparition d'un champ magnétique parasite, induit par des courants de FOUCAULT circulant dans le blindage. Ce champ parasite perturbe la mesure du champ terrestre et nuit à la détection des anomalies.

D'une manière générale, il faut viser à ce que, la sonde blindée étant mise en rotation, elle ne voie pas ses performances dégradées par la présence d'un champ magnétique induit parasite. C'est le rôle du blindage. L'homme du métier ayant à le fabriquer, lui donne en général une forme cylindrique comme dans l'exemple de la figure 1, ou éventuellement parallélépipédique, car ces formes sont commodes à réaliser.

Or, le Demandeur a montré qu'avec de telles formes, dans l'application envisagée, les mouvements de rotation auxquels le blindage est soumis provoquent l'apparition d'un champ magnétique induit parasite non négligeable. Ce champ induit se compose avec le champ terrestre à mesurer et la mesure s'en trouve perturbée.

La solution préconisée par le Demandeur est alors d'utiliser un blindage de forme sphérique. Un tel blindage, associé à une sonde de magnétomètre (à RMN ou à RPE) et soumis aux mouvements décrits précédemment, verra encore l'apparition d'un champ induit, mais dans ce cas, ce champ sera toujours perpendiculaire au champ terrestre à mesurer, comme on le comprendra mieux par la suite. Les deux vecteurs s'additionneront mais leur orthogonalité minimisera la perturbation.

Le Demandeur a pu montrer ainsi que le champ parasite induit par rotation, dans le cas d'un magnétomètre muni d'un blindage cylindrique de diamètre 18 cm et de longueur de 20 cm, est de 400 picoTesla pour une vitesse de rotation de 1 degré par seconde tandis que, pour un magnétomètre muni d'un blindage sphérique conformément à l'invention, avec un diamètre de 30 cm, le champ induit parasite tombe à 10 picoTesla pour la même vitesse de rotation, ce qui représente un gain d'un facteur 40.

Il faut observer, qu'en soi, un blindage sphérique n'est pas nouveau. Un tel blindage est décrit par exemple dans l'article de K. HIRAO et al. intitulé "Large Spherical Magnetic Shield Room", publié dans la revue "Jour. Geomag. Geoelectr.", vol. 37, 581-588, 1985. Il faut souligner cependant que de tels blindages sont destinés à isoler complétement un laboratoire de mesure. Dans ces conditions, ces blindages présentent de très grandes dimensions (diamètre de 6 à 8 mètres) et sont composés de matériaux ferromagnétiques (donc à très haute permittivité) pour empêcher totalement le champ magnétique terrestre (ainsi que d'autres champs parasites extérieurs) de pénétrer dans le laboratoire de mesure. Il s'agit donc d'un blindage magnétique total.

Dans le problème que se propose de résoudre l'invention, il ne s'agit certainement pas de bloquer le champ magnétique terrestre, puisque c'est justement le champ qu'il s'agit de mesurer. Le blindage ne doit donc pas être magnétique mais plutôt électromagnétique. Il faut rappeler à cet égard, la différence existant entre un blindage magnétique et un blindage électromagnétique. Un blindage magnétique est constitué d'une ou de plusieurs couches de matériaux ferromagnétiques, dont la perméabilité relative est grande devant l'unité, ce qui assure une atténuation du champ magnétique, même pour des champs continus. En revanche, un blindage électromagnétique est formé de matériaux (une ou plusieurs couches) diamagnétiques ou paramagnétiques comme le cuivre, l'argent, l'aluminium, dont la perméabilité relative est très proche de l'unité. L'atténuation pour les champs continus est alors nulle et elle va croissant à mesure que la fréquence augmente.

Un blindage électromagnétique dont l'épaisseur est inférieure à l'épaisseur de peau, se comporte comme un filtre passe-bas du premier ordre (atténuation de 6 dB/octave). Pour une épaisseur de blindage supérieure à l'épaisseur de peau, l'atténuation augmente plus vite.

Pour en revenir au document antérieur relatif aux blindages sphériques, il faut souligner pour finir qu'il ne fait pas allusion, et pour cause, à la rotation du blindage. Les problèmes posés par cette rotation n'y sont donc pas été posés, et, corrélativement les avantages liés à la forme sphérique n'y sont pas mentionnés.

On peut donc dire, qu'en dépit d'une analogie de vocabulaire, le problème technique résolu dans cet art antérieur n'est pas celui que s'attache à résoudre l'invention.

La forme sphérique ayant été adoptée conformément à l'invention, reste à résoudre des problèmes d'un autre ordre, à savoir la réalisation pratique de cette forme. L'invention préconise l'utilisation de deux hémisphères assemblés l'un à l'autre autour de la sonde.

De toute façon, les caractéristiques et avantages de l'invention apparaîtront mieux à la lumière de la description qui va suivre. Cette description porte sur des exemples de réalisation donnés à titre explicatif et nullement limitatif et elle se réfère à des dessins annexés sur lesquels :

– la figure 1, déjà décrite, montre un magnétomètre de l'art antérieur ;

– la figure 2 est un schéma montrant comment le champ réel et le champ parasite se composent ;

– la figure 3 montre, en coupe, un magnétomètre à blindage sphérique selon l'invention.

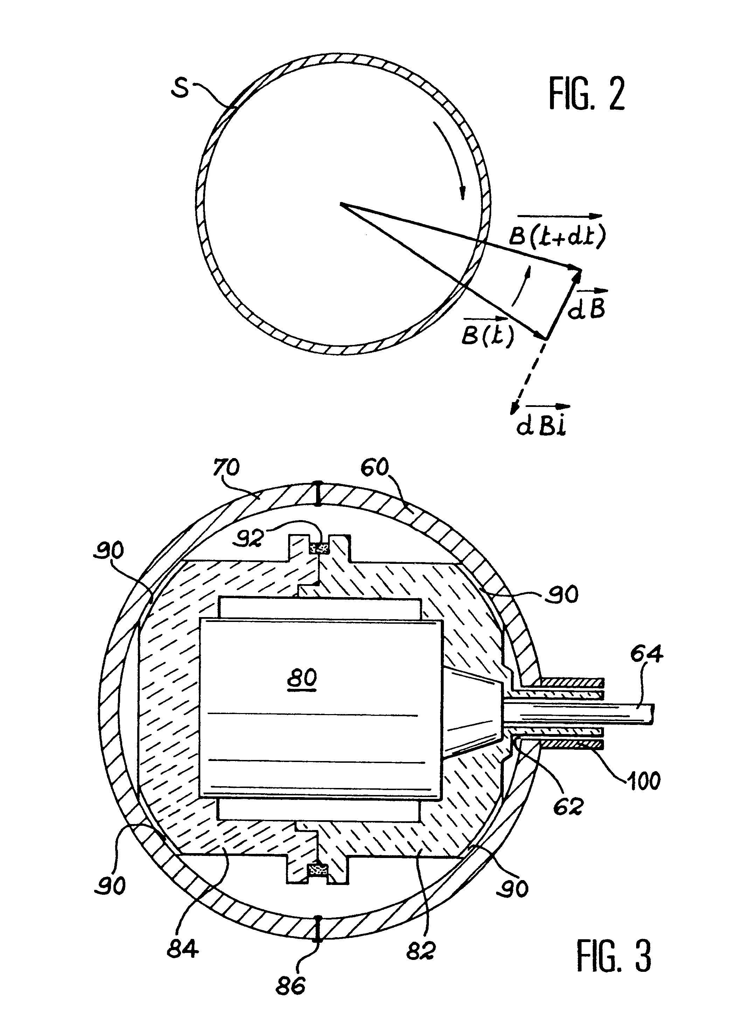

La figure 2 montre pourquoi un blindage sphérique réduit l'effet du champ magnétique parasite induit par la rotation de l'écran.

Une sphère conductrice S est supposée plonger dans un champ magnétique uniforme $\vec{B(t)}$, où t est le temps. Si la sphère est mise en rotation, cela équivaut, pour la sphère, à la mise en rotation du champ dans le sens opposé. Pour la sphère, le champ à l'instant t+dt devient $\vec{B(t+dt)}$. Tout se passe comme ci un champ $\vec{dB}$ était venu se composer avec $\vec{B(t)}$, le champ $\vec{dB}$ étant sensiblement perpendiculaire à $\vec{B(t)}$ (en première approximation).

La variation du champ se traduit par l'apparition de courants induits dans la sphère dont le sens est tel que le champ induit $\vec{dBi}$ s'oppose à la variation qui lui a donné naissance (loi de Lenz). Ce champ induit est opposé à $\vec{dB}$. Il est donc, lui aussi, sensiblement perpendiculaire à $\vec{B(t)}$. En conséquence, et toujours en première approximation, le champ induit ne modifie pas sensiblement le champ à mesurer. La forme sphérique entraîne que cette conclusion est valable quelle que soit l'orientation du champ $\overrightarrow{B(t)}$. Le blindage et son magnétomètre peuvent donc être mis en rotation dans des sens quelconques, la perturbation, qui est déjà du second ordre, sera la même quelle que soit l'orientation du blindage par rapport au champ à mesurer.

La figure 3 montre un mode de réalisation d'un magnétomètre à blindage sphérique selon l'invention.

Tel que représenté, le blindage est constitué, d'une part, d'un premier hémisphère 60 percé d'une ouverture 62 servant de traversée pour un câble d'alimentation 64 et d'autre part, d'un second hémisphère 70 assemblé au premier.

Le premier hémisphère 60 est relié à un queusot 100 disposé autour de l'ouverture 62 et entourant le câble 64 d'alimentation de la sonde 80. Le queusot 100 a de préférence une longueur au moins égale à son diamètre. Plus le queusot est long, meilleure sera l'atténuation aux champs alternatifs extérieurs.

La sonde porte la référence 80. Elle peut être du type RMN ou RPE. Dans le premier cas, elle peut être conforme à celle de la figure 1. La sonde est tenue dans un support isolant amagnétique formé de deux parties assemblées 82, 84 disposées chacune dans l'un des hémisphères et en appui sur la surface intérieure de ceux-ci.

Les deux hémisphères 60 et 70 sont soudés l'un à l'autre sur toute leur épaisseur, le long d'un cordon 86.

De préférence, les deux hémisphères sont soudés l'un à l'autre par un cordon de soudure obtenu par faisceau d'électrons. La température de soudage peut être de 600°C. La soudure s'effectue sur toute l'épaisseur du blindage.

Pour permettre l'établissement d'un vide partiel à l'intérieur du blindage lors de la soudure par faisceau d'électrons, chaque partie 82 ou 84 du support comprend des rainures 90 sur les surfaces en appui sur les hémisphères.

Le support est entouré d'un anneau 92 disposé sous la ligne de soudure 86 des deux hémisphères 60 et 70, pour protéger le support lors de l'opération de bombardement électronique.

Les supports 82 et 84 sont en matériau isolant et amagnétique, par exemple en DELRIN (marque déposée).

Pour éviter que le champ créé dans la sonde par les enroulements d'excitation soit une source de courant induit dans le blindage, le diamètre de celui-ci est de préférence supérieur à 3 fois le diamètre de la sonde.

Le blindage 60, 80 est en un métal comme l'aluminium, le cuivre ou l'argent.

Le montage des pièces illustrées s'effectue dans l'ordre suivant :

1) soudage de l'hémisphère 60 et du queusot 100 pour constituer un ensemble A ;

2) assemblage de la sonde 80 avec son câble 64 dans la partie 82 du support, pour constituer un ensemble B ;

3) montage de l'anneau de protection 86 sur la partie 84 du support pour constituer un ensemble C ;

4) assemblage des ensembles B et C pour constituer un ensemble D ;

5) assemblage des ensembles D et A pour constituer un ensemble E ;

6) enfin, assemblage par soudage de l'hémisphère 70 et de l'ensemble E.

## Revendications

1. Magnétomètre comprenant une sonde à résonance magnétique (80) entourée d'un blindage électromagnétique, caractérisé par le fait que ce blindage (60, 70) est sphérique.

2. Magnétomètre selon la revendication 1, caractérisé par le fait que le blindage est constitué d'un premier hémisphère (60) percé d'une ouverture (62) servant de traversée pour un câble d'alimentation (64) de la sonde (80) et d'un second hémisphère (70) assemblé au premier.

3. Magnétomètre selon la revendication 2, caractérisé par le fait que la sonde (80) est tenue dans un support isolant amagnétique formé de deux parties assemblées (82, 84) disposées chacune dans l'un des hémisphères (60, 70) et en appui sur la surface intérieure de ceux-ci.

4. Magnétomètre selon la revendication 2, caractérisé par le fait que les deux hémisphères (60, 70) sont soudés l'un à l'autre sur toute leur épaisseur.

5. Magnétomètre selon la revendication 4, caractérisé par le fait que les deux hémisphères (60, 70) sont soudés l'un à l'autre par un cordon de soudure (86) obtenu par faisceau d'électrons.

6. Magnétomètre selon les revendications 3 et 5, caractérisé par le fait que, pour permettre l'établissement d'un vide partiel à l'intérieur du blindage lors de la soudure par faisceau d'électrons, chaque partie du support comprend des rainures (90) sur les surfaces en appui sur les hémisphères (60, 70).

7. Magnétomètre selon la revendication 5, caractérisé par le fait que le support (82, 84) est entouré d'un anneau de protection (92) disposé sous la ligne de soudure des deux hémisphères.

8. Magnétomètre selon la revendication 2, caractérisé par le fait que le premier hémisphère (60) est relié à un queusot (100) disposé autour de l'ouverture (62) et entourant le câble d'alimentation (64) de la sonde (80).

9. Magnétomètre selon la revendication 8, caractérisé par le fait que le queusot (100) a une longueur au moins égale à son diamètre.

10. Magnétomètre selon l'une quelconque des revendications 1 à 9, caractérisé par le fait que le diamètre du blindage (60, 70) est supérieur à 3 fois le diamètre de la sonde (80).

11. Magnétomètre selon l'une quelconque des revendications 1 à 10, caractérisé par le fait que le blindage (60, 70) est en un métal pris dans le groupe consistant en l'aluminium, le cuivre, l'argent.

FIG. 1

FIG. 2

FIG. 3

**Office européen des brevets**

# RAPPORT DE RECHERCHE EUROPEENNE

Numero de la demande

EP 91 40 0775

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| D,X | Journal of geomagnetism and geoelectricity vol. 37, 1985, Tokyo, Japan pages 581 - 588; K.Hirao et al.: "Large spherical magnetic shield room" * abrégé * * page 582, lignes 17 - 21 * | 1, 11 | G01R33/24 G01R33/42 |
| D,Y | --- | 2 | |
| Y | EP-A-0206931 (CEA) * colonne 2, lignes 22 - 24 * | 2 | |
| A | * colonne 4, lignes 10 - 12 * | 8 | |
| D | & FR-2583887 | | |
| A | --- US-A-4546317 (G.F.HINTON) * colonne 2, lignes 11 - 21 * * colonne 3, lignes 6 - 7 * * figure * | 3 | |
| A | --- DE-A-3438702 (LICENTIA PATENT-VERWALTUNG-GMBH) * abrégé * | 4 | |
| | ----- | | **DOMAINES TECHNIQUES RECHERCHES (Int. Cl.5 )** G01R |

Le présent rapport a été établi pour toutes les revendications

| Lieu de la recherche | Date d'achèvement de la recherche | Examinateur |
|---|---|---|
| BERLIN | 27 MAI 1991 | MOUTARD P. |